# EUROPÄISCHE PATENTSCHRIFT

(11) **EP 1 395 837 B1**
(45) Veröffentlichungstag und Bekanntmachung des Hinweises auf die Patenterteilung: **04.01.2006**
(21) Anmeldenummer: 02735055.2
(22) Anmeldetag: 03.05.2002
(51) Int. Cl.: G01R 1/00, G01R 15/20, G01R 33/00

(54) **VORRICHTUNG ZUR MESSUNG EINER B-KOMPONENTE EINES MAGNETFELDES, MAGNETFELDSENSOR UND STROMMESSER**
DEVICE FOR MEASURING A B-COMPONENT OF A MAGNETIC FIELD, A MAGNETIC FIELD SENSOR AND AN AMMETER
DISPOSITIF POUR MESURER UNE COMPOSANTE B DE CHAMP MAGNETIQUE, CAPTEUR DE CHAMP MAGNETIQUE ET AMPEREMETRE

(30) Priorität: 25.05.2001 DE 10125425
(43) Veröffentlichungstag der Anmeldung: 10.03.2004
(73) Patentinhaber: ROBERT BOSCH GMBH, 70442 Stuttgart (DE)
(72) Erfinder: HAUENSTEIN, Henning, 72762 Reutlingen (DE)
(86) Internationale Anmeldenummer: PCT/DE2002/001601
(87) Internationale Veröffentlichungsnummer: WO 2002/095423

(56) Entgegenhaltungen:
- EP-A- 0 402 271
- GB-A- 1 280 719
- US-A- 3 668 439
- US-A- 4 516 144

## Beschreibung

Die Erfindung betrifft eine Vorrichtung zur Messung einer B-Komponente eines Magnetfeldes gemäß dem Oberbegriff des Anspruchs 1 sowie einen Magnetfeldsensor und einen Strommesser gemäß den weiteren nebengeordneten Ansprüchen.

### Stand der Technik

Es ist derzeit Stand der Technik, magnetische Felder, beispielsweise von Stromleitern, durch Magnetfeldsensoren, beispielsweise Hallsensoren, zu messen. Hierbei werden gemäß dem Stand der Technik Flusskonzentratoren verwendet, um auch noch sehr kleine Magnetfelder mittels solcher Magnetfeldsensoren messen zu können. Solche Flusskonzentratoren bestehen im Wesentlichen aus hochpermeablen Materialien, die relativ zum zu messenden Magnetfeld derart angeordnet sind, dass sich aus der Kombination eines Magnetfeldsensors und eines Flusskonzentrators eine Erhöhung der Meßempfindlichkeit ergibt. Nachteilig bei Flusskonzentratoren ist, dass diese Sättigungseffekte und Hystereseerscheinungen zeigen. Weiterhin ist auch der Bauraumbedarf und die Kosten von Flusskonzentratoren nachteilig.

Die US-PS 4,516,144 beschreibt mehrere Methoden zur Herstellung eines vorteilhaften Hallsensors, bei denen einerseits zwei zusätzliche, abstoßend wirkende, Diffusionsgebiete vorhanden sind, die lediglich eine Fokussierung des Ladungsträgerstromes bewirken, indem sie einen Teil der Ladungsträger ausblenden. Der Öffnungswinkel der Ladungsträgerverteilung wird dadurch verkleinert, wobei jedoch ein Verlust in der Anzahl der zur Detektion verfügbaren Ladungsträger in Kauf genommen wird, damit wird die Effizienz jedoch nicht gesteigert, sondern verringert. Andererseits sind zwei weitere Diffusionsgebiete vorhanden, die ein quer zur Bewegungsrichtung der Ladungsträger verlaufendes, elektrisches Feld erzeugen, wobei diese Feldverteilung jedoch nicht zur Winkelverstärkung bzw. zu Optimierung der Ablenkung der Teilchen in dem von uns angestrebten Sinn. Es wird vielmehr lediglich der zentrale Ladungsträgerfluss als Ganzes nach links oder rechts oder abgelenkt, um ggf. einen Offset auszugleichen.

Die US-PS 3,668,439 beschreibt die Verwendung einer Transistoranordnung als magnetfeldsensitives Element. Die Ausgestaltung ist dabei so, dass eine gewisse Felderzeugung im magnetfeldsensitiven Element auftritt. Die auftretenden elektrischen Felder bewirken jedoch keine Winkelverstärkung für die auszuwertenden geladenen Teilchen und stellen auch keine lateral ausgedehnte Potenzialbergstruktur dar.

Die Druckschriften EP-A-0 402 271 und GB-A-1 280 719 beschreiben weitere magnetfeldempfindliche Halbleiterstrukturen, die Magnetfeldmessungen ermöglichen. Spezielle Feldanordnungen zur Erzeugung einer lateralen Potenzialbergstruktur sind jedoch nicht vorhanden.

### Vorteile der Erfindung

Aus den obengenannten Gründen ist es sinnvoll, die Empfindlichkeit von Magnetfeldsensoren so weit wie möglich zu steigern, um auf diese Weise einen größeren Dynamikumfang bzw. größere Dynamikbereiche von messbaren Magnetfeldern zu erreichen.

Moderne Technologien offenbaren immer mehr Anwendungsgebiete für sehr empfindliche Magnetfeldmessmethoden. Insbesondere im Automobilbereich wächst die Zahl potentieller Einsatzbereiche für Magnetfeldsensoren, zumal die Magnetfeldmessung unter anderem zur berührungslosen, verlustarmen und potentialgetrennten Messung von Strömen genutzt werden kann. Beispiele sind die Bestimmung elektrischer Betriebsparameter von Generatoren und elektrischen Antrieben oder die hochsensitive Überwachung des Batteriezustandes im sogenannten Energie-Batterie-Management. Im Allgemeinen müssen Ströme vom Milliampere-Bereich bis zum Kiloampere-Bereich gemessen werden, was einen Meßbereich von ca. 5 bis 6 Größenordnungen erfordert.

Die erfindungsgemäße Vorrichtung gemäß dem Oberbegriff des Anspruchs 1 sowie gemäß der nebengeordneten Ansprüche weist den Vorteil auf, dass die Empfindlichkeit der Magnetfeldmessung gegenüber bekannten Sensoren, insbesondere gegenüber Hallsensoren, erhöht ist. Hierbei bleibt erfindungsgemäß dennoch der lineare Zusammenhang zwischen dem Messsignal der erfindungsgemäßen Vorrichtung und dem zu messenden Magnetfeld erhalten. Durch die Erhöhung der Sensorempfindlichkeit kann in vielen Anwendungen auf zusätzliche flusskonzentrierende Maßnahmen, wie beispielsweise Magnetkreise, verzichtet werden, so dass eine erfindungsgemäße Vorrichtung zur Messung eines Magnetfeldes erheblich einfacher, kostengünstiger und mit geringerem Montageaufwand als eine herkömmliche Vorrichtung dieser Art gestaltbar ist. Weiterhin ist es erfindungsgemäß von Vorteil, dass der Ablenkwinkel, den die Ladungsträger aufgrund des zu messenden Magnetfeldes erfahren, größer ist als bei herkömmlichen, nach dem Hallprinzip arbeitenden Magnetfeldsensoren. Hierdurch wird durch eine Verstärkung der Magnetfeldwirkung auf die Flugbahn von Ladungsträgern die Empfindlichkeit gegenüber dem Standard-Hallsensor vergrößert. Weiterhin ist vorteilhaft, dass die Empfindlichkeitssteigerung des erfindungsgemäßen Magnetfeldsensors allein durch das Design der Vorrichtung zur Magnetfeldmessung erreicht wird. Hierdurch entsteht ein hochsensitives Bauelement, das in Standardprozesstechnik, wie beispielsweise in Bipolar-, BCD- oder CMOS-Prozesstechnik, leicht und kostengünstig herstellbar ist. Weiterhin ist insbesondere vorteilhaft, dass gemäß der vorliegenden Erfindung ein linearer Zusammenhang zwischen dem zu messenden Magnetfeld und dem von der Vorrichtung hervorgerufenen Messsignal besteht.

In den Unteransprüchen sind vorteilhafte Weiterbildungen und Verbesserungen der erfindungsgemäßen Vorrichtung angegeben.

Insbesondere ist vorteilhaft, dass zwischen einem ersten Anschluß und einem zweiten Anschluß ein elektrisches Feld vorgesehen ist, wodurch die Ladungsträger in das Gebiet eingebracht werden. Hierdurch wird die Einbringung der Ladungsträger und deren Drift durch das Gebiet auf einfache und zuverlässige Weise realisiert.

Weiterhin ist von Vorteil, dass zur Erzeugung der Feldverteilung entweder ein laterales elektrischer Feld oder ein lateraler Teilchengradient oder ein laterales Diffusionsprofil oder die Modulation der Bandkanten oder die Modulation der Ferminiveaus im Ortsraum, z.B durch eingebaute Potentialberge in n-i-p-i-Strukturen, vorgesehen ist. Hierbei wird als n-i-p-i-Struktur in einem Halbleiter eine Struktur aufgefaßt, bei der abwechselnd n-dotierte, intrinsische, p-dotierte und intrinsische Halbleiterschichten vorgesehen sind. Die Schichtenfolge n-i-p-i kann auch periodisch fortgesetzt sein: n-i-p-i-n-i-p-in-i-p-i...... Durch die Variation zwischen n und p Schichten, ergibt sich eine Potentialbergstruktur, wie man sie vom einfachen p-n-Übergang her kennt. Unter Umständen genügt auch eine geeignet dimensionierte Schichtenfolge p-n-p-n-p-n-.... ohne intrinsische Zwischenschicht, um das gewünschte Potentialgebirge zu erzeugen. Dadurch ist die erfindungsgemäße Vorrichtung mittels verschiedener Herstellverfahren realisierbar, so dass jeweils das kostengünstigste bzw. optimalste Verfahren zur Verwendung in Betracht gezogen werden kann.

### Zeichnung

Ausführungsbeispiele der Erfindung sind in der Zeichnung dargestellt und in der nachfolgenden Beschreibung näher erläutert. Es zeigen
Figur 1 die schematische Darstellung des Standard-Hallprinzips,
Figur 2 eine Modelldarstellung der Ablenkung von Elektronen im Magnetfeld,
Figur 3 eine Prinzipskizze einer ersten Ausführungsform der erfindungsgemäßen Vorrichtung,
Figur 4 eine Prinzipskizze einer zweiten Ausführungsform der erfindungsgemäßen Vorrichtung,
Figur 5 eine Prinzipskizze einer dritten Ausführungsform der erfindungsgemäßen Vorrichtung und
Figur 6 eine Prinzipskizze einer vierten Ausführungsform der erfindungsgemäßen Vorrichtung.

### Beschreibung der Ausführungsbeispiele

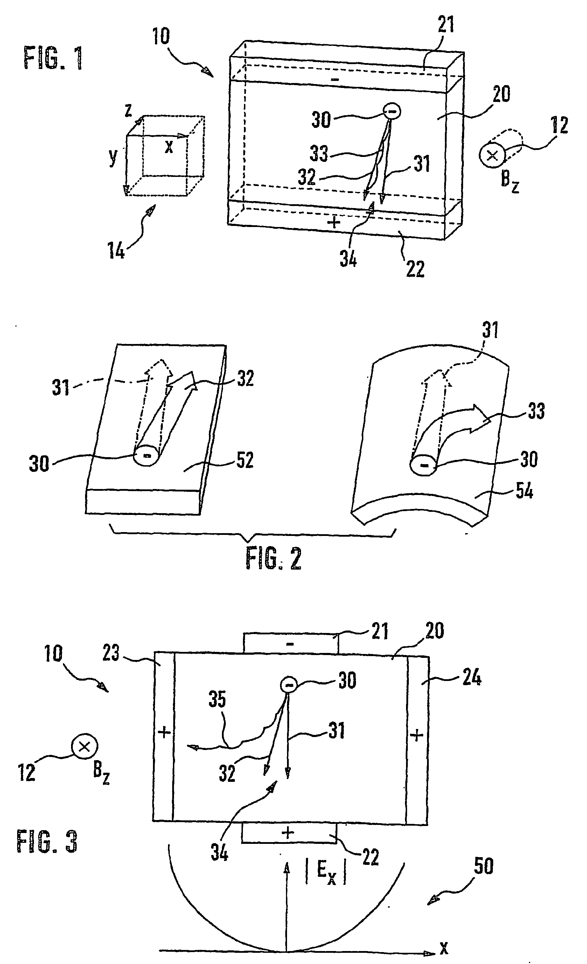

In Figur 1 ist schematisch das Funktionsprinzip eines Standard-Hallsensors 10 dargestellt. Der Hallsensor 10 umfasst ein Gebiet 20, welches in der Regel in einem Halbleitersubstrat vorgesehen ist. Weiterhin umfasst der Hallsensor 10 einen ersten Anschluß 21 und einen zweiten Anschluß 22. Zwischen dem ersten Anschluß 21 und dem zweiten Anschluß 22 ist ein nichtdargestelltes elektrisches Feld vorgesehen, wodurch ein Ladungsträger 30, der in der Figur als negativer Ladungsträger 30 mit einem "Minus"-Zeichen versehen ist, von dem ersten Anschluß 21 durch das Gebiet 20 zum zweiten Anschluß 22 bewegt wird. Entsprechend liegt der erste Anschluß 21 auf negativem Potential und ist mit einem Minuszeichen bezeichnet, währenddem der zweite Anschluß 22 mit einem Pluszeichen bezeichnet ist und auf positivem Potential liegt. Durch die angelegte Spannung zwischen dem ersten Anschluß 21 und dem zweiten Anschluß 22 wird der Ladungsträger 30 in das Gebiet 20 ausgehend von dem ersten Anschluß 21 eingebracht, wobei dies entlang einer Einbringungsrichtung geschieht, die in der Figur senkrecht von oben nach unten zwischen dem ersten Anschluß 21 und dem zweiten Anschluß 22 vorgesehen ist. Hierdurch wird der Ladungsträger 30 entlang einer ersten Bewegungsrichtung 31, die mittels eines senkrecht von oben nach unten weisenden Pfeils 31 bezeichnet ist, zwischen dem ersten Anschluß 21 und dem zweiten Anschluß 22 bewegt.

Für den Fall, dass senkrecht auf die Einbringungsrichtung und entsprechend senkrecht auf die erste Bewegungsrichtung 31 des Ladungsträgers 30 eine Magnetfeldkomponente BZ, die mit dem Bezugszeichen 12 versehen ist, eines Magnetfeldes vorhanden ist, wobei die Magnetfeldkomponente 12 auch als B-Komponente 12 bezeichnet wird und in Figur 1 in die Zeichenebene hineinweist, so erfährt der Ladungsträger 30 in dem Bereich 20 eine Ablenkung gemäß der Lorenzkraft, so dass sich der Ladungsträger 30 gemäß dem Standard-Hall-Prinzip nicht mehr entlang der ersten Bewegungsrichtung 31 sondern gemäß einer zweiten Bewegungsrichtung 32 bewegt, die in Figur 1 mittels eines in einem Winkel zu der ersten Bewegungsrichtung 31 angeordneten und mit dem Bezugszeichen 32 versehenden Pfeil dargestellt ist. Der Winkel zwischen der ersten Bewegungsrichtung 31 und der zweiten Bewegungsrichtung 32 des Ladungsträgers 30, der im Folgenden auch als Winkel α bezeichnet wird, ist abhängig von der Stärke der Magnetfeldkomponente oder B-Komponente 12 in Z-Richtung, d.h. in die Papierebene der Figur 1 hinein. In Wirklichkeit übt die Lorenzkraft auf den Ladungsträger 30 eine Kraft derart aus, dass aus einer ursprünglich geraden Flugbahn eine gekrümmte Kreisbahn (Zykloide) entsteht, die jedoch deshalb nicht erkennbar ist, weil der Ladungsträger 30 im realen Gebiet 20 immer nur etwa 100 fs lang ballistisch, d.h. ungestört fliegen kann, bevor er mit den Atomen des Kristallgitters zusammenstößt. Die während einer Zykloide erreichbare Winkeländerung ist daher äußerst gering. Durch den Stoß mit dem Kristallgitter verliert der Ladungsträger 30 seine bisherige Richtungsinformation und seine Geschwindigkeit, so dass er anschließend erneut beschleunigt werden muß und vom Ort des Stoßes aus eine weitere Zykloidenbahn beschreibt. Mittels des Bezugszeichens 33 ist entlang der zweiten Bewegungsrichtung 32 die Trajektorie des Ladungsträgers 30 mittels mehrerer hintereinander angeordneter Zykloiden angedeutet.

Zur besseren Verdeutlichung der in Figur 1 und in den folgenden Figuren verwendeten Richtungen ist im linken Teil der Figur 1 ein Koordinatensystem 14 dargestellt, welches eine x-Achse, eine y-Achse und eine z-Achse aufweist, die jeweils mit Pfeilen versehen sind, wobei die Pfeile von einem gemeinsamen Ursprung ausgehen. Das Koordinatensystem 14 ist leicht perspektivisch angedeutet, wobei die z-Richtung in die Zeichenebene hineinweist, wobei die x-Achse der Horizontalen entspricht und wobei die y-Achse der Vertikalen entspricht.

Die Gesamtflugbahn eines Ladungsträgers 30 im Gebiet 20 setzt sich wie die Bezugszeichen 32 und 33 andeuten, aus gekrümmten Zykloidenbahnstücken zusammen, die nacheinander jeweils für etwa 100 fs durchflogen werden. Der Ablenkwinkel α, der sich insgesamt einstellt, ist deshalb im Mittel identisch zu dem Ablenkwinkel einer einzelnen Zykloidenteilbahn. Die dadurch erreichte Winkeländerung der Flugbahn ist äußerst gering, typischerweise weniger als 1°. Dementsprechend gering sind auch die makroskopisch erzielbaren Effekte, d.h. die Empfindlichkeit der Magnetfeldmessung der B-Komponente 12 in einem Hallelement bei dem der gemäß der ersten Bewegungsrichtung 31 fließende Strom von der B-Komponente 12 seitlich gemäß der zweiten Bewegungsrichtung 32 abgelenkt wird. Erfindungsgemäß wird der Ablenkwinkel 34 bei der vorgeschlagenen Vorrichtung vergrößert.

Die Prinzipien, die zu einer solchen Vergrößerung des Ablenkwinkels führen, sind in Figur 2 anhand eines Kugelmodells verdeutlicht. Auf der linken Seite der Figur 2 sind die Verhältnisse angegeben, wie sie im Standard-Hallelement gemäß der Figur 1 vorliegen. Hier bewegen sich die Ladungsträger 30 auf einer Ebene 52. Der gerade Pfeil im linken Teil der Figur 2 gibt die erste Bewegungsrichtung 31 des Ladungsträgers 30 an und ist entsprechend mit dem Bezugszeichen 31 versehen. Die zweite Bewegungsrichtung 32 entspricht der Bewegungsrichtung des Ladungsträgers 30 bei "eingeschaltetem" Magnetfeld. Durch die Ablenkung der Ladungsträger 30 gemäß der zweiten Bewegungsrichtung 32 entsteht die im Standard-Hallelement bekannte Hallspannung, die der Ablenkrichtung bzw. dem Ablenkwinkel entgegenwirkt. Dies ist im linken Teil der Figur 2 dadurch dargestellt, dass die Ebene 52 perspektivisch "nach rechts ansteigt". Die nach rechts gemäß der zweiten Bewegungsrichtung 32 abgelenkten Ladungsträger 30 müssen somit sogar gegen die Hallspannung "anlaufen". Auf der rechten Seite der Figur 2 sind die Verhältnisse gemäß der vorliegenden Erfindung dargestellt. Die Ladungsträger 30 bewegen sich gemäß der vorliegenden Erfindung nicht mehr auf der Ebene 52 sondern auf einer "gewölbten Potentialberg-Struktur", die mit dem Bezugszeichen 54 versehen ist. Durch die Struktur 54 erfahren die Ladungsträger 30 ausgehend von deren erster Bewegungsrichtung 31 (bei "ausgeschaltetem" Magnetfeld) eine stärkere Ablenkung und zwar gemäß einer dritten Bewegungsrichtung 33, die durch einen Pfeil dargestellt ist, der mit dem Bezugszeichen 33 versehen ist. Die Ladungsträger 30 erfahren daher gemäß der vorliegenden Erfindung eine zusätzliche laterale Kraftwirkung, sobald sie von einem Magnetfeld aus der zentralen Flugbahn 31 seitlich abgelenkt werden. Diese seitliche Kraftwirkung verstärkt den Ablenkeffekt des in der Figur 2 nicht dargestellten "eingeschalteten" Magnetfeldes. Eine solche lateral zunehmende Kraftwirkung kann in einem realen Halbleiterelement auf verschiedene Arten sehr vorteilhaft realisiert werden:
durch laterale elektrische Felder,
durch laterale Teilchengradienten,
durch laterale Diffusionsprofile,
durch Modulation der Bandkanten oder
durch Modulation des Ferminiveaus im Ortsraum, beispielsweise durch eingebaute Potentialberge in sogenannte n-i-p-i-Strukturen. Die Bezeichnung "lateral" bezieht.sich hier auf die in Figur 1 dargestellte x-Richtung, d.h. auf die Richtung in der Zeichenebene senkrecht zur ersten Bewegungsrichtung 31 der Ladungsträger 30.

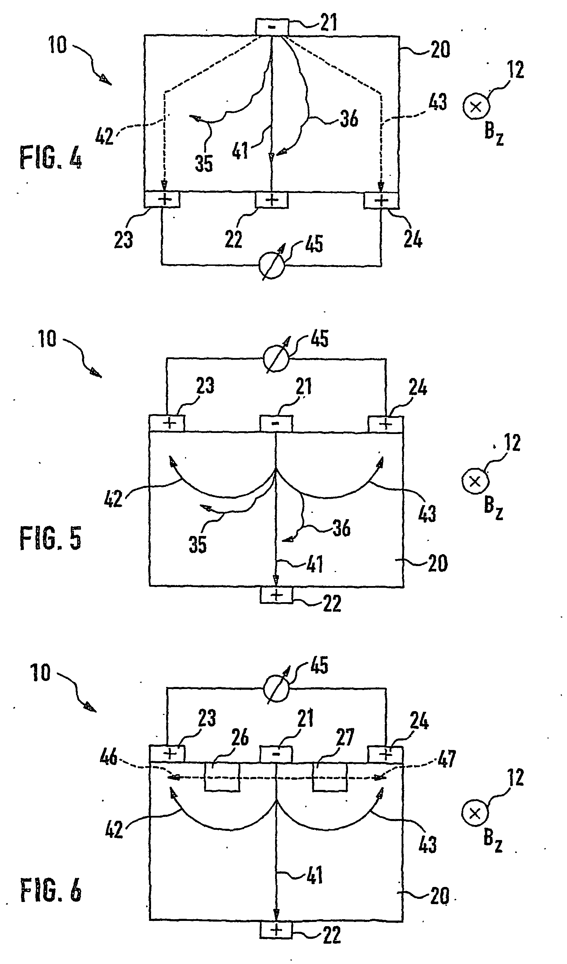

In Figur 3 ist der Effekt einer lateral zunehmenden Kraft auf die Ladungsträgerbewegung bei eingeschaltetem Magnetfeld, d.h. bei nichtverschwindender B-Komponente 12 dargestellt. Wiederum ist der Bereich 20 vorgesehen, der insbesondere als Bereich in einer Halbleiteranordnung vorgesehen ist. Weiterhin ist wiederum der erste Anschluß 21 und der zweite Anschluß 22 vorgesehen, wobei der erste Anschluß beispielhaft als negativer Anschluß 21 und der zweite Anschluß 22 beispielhaft als positiver Anschluß vorgesehen ist. Der erste und zweite Anschluß 21, 22 ist nicht über die gesamte Ausdehnung in x-Richtung des Bereichs 20 vorgesehen, sondern im Wesentlichen mittig vorgesehen. Direkt an den Bereich 20 sind seitlich eine erste Elektrode 23 und eine zweite Elektrode 24 vorgesehen. Sowohl die erste Elektrode 23 als auch die zweite Elektrode 24 sind beispielhaft als positive Elektroden 23, 24 vorgesehen. Dargestellt ist in Figur 3 wiederum die Anordnung 10, diesmal jedoch gemäß einer ersten Ausführungsform der Erfindung. Innerhalb des Bereichs 20 ist in seitlicher Richtung, d.h. in x-Richtung, im unteren Bereich der Figur 3 eine Feldverteilung 50 eines ersten elektrischen Feldes entlang der x-Richtung dargestellt. Die Feldverteilung 50 gibt den Betrag der Komponente in x-Richtung des ersten elektrischen Feldes an. Das erste elektrische Feld ist nicht explizit in Figur 3 dargestellt. Erkennbar ist, dass die x-Komponente des ersten elektrischen Feldes betragsmäßig ausgehend von der Mitte des Bereichs 20 seitlich, d.h. sowohl in die positive als auch in die negative x-Richtung, betragsmäßig anwächst. Dies bringt es mit sich, dass zunächst, sobald der Ladungsträger 30 durch Einschalten der B-Komponente 12 des zu messenden Magnetfeldes sich nicht mehr entlang der ersten Bewegungsrichtung 31 von dem ersten Anschluß 21 zum zweiten Anschluß 22 bewegt, sondern seitlich gemäß der zweiten Bewegungsrichtung 32 abgelenkt wird, so dass zumindest anfänglich der Ablenkwinkel 34 entsteht, und dass weiterhin der Ladungsträger 30 durch die seitliche Ablenkung aufgrund der Feldverteilung 50 eine zusätzliche seitliche Kraft erfährt. Eine mit dem Bezugszeichen 35 versehene Zykloidenbahn des Ladungsträgers 30, die gemäß der dritten Bewegungsrichtung 33 aus Figur 2 eine stärkere Ablenkung aufweist als die zweite Bewegungsrichtung 32 in Figur 3, entsteht dabei dadurch, dass durch die von der Feldverteilung 50 hervorgerufene zusätzliche laterale Kraft in x-Richtung, der Ladungsträger 30 weiter als gemäß der zweiten Bewegungsrichtung 32 abgelenkt wird, wobei die Zykloidenteilbahn, die der Ladungsträger 30 bei jedem weiteren Teilstück nach einem Stoß mit dem Kristallgitter ballistisch durchfliegt, stärker geneigt ist als die vorherige Zykloidenteilbahn, weil neben der Magnetfeldwirkung durch die Lorenzkraft auch die in das Gebiet 20 eingebaute und durch die Feldverteilung 50 dargestellte Potentialbergstruktur eine seitliche Kraft in gleicher Richtung ausübt. Dadurch wird der Ladungsträger 30 noch etwas weiter seitlich abgelenkt, wo, weil die Feldverteilung 50 seitlich nach außen hin betragsmäßig monoton ansteigt, die laterale Kraftwirkung nochmals stärker wird, und so fort. Auf diese Weise neigt sich jede weitere Zykloidenteilbahn mehr auf die Seite, so dass der Ablenkwinkel der Flugbahn immer größer wird. Der Effekt der B-Komponente 12, welcher selbst immer nur eine sehr geringe Winkeländerung pro Zykloidenteilbahn induziert, wird durch die Wirkung der Feldverteilung 50 drastisch verstärkt. Insgesamt sind daher sehr hohe Ablenkwinkel von wesentlich größer als 1° erreichbar, die ein Vielfaches der Ablenkung von herkömmlichen Hallsensoren betragen.

Durch den ersten Anschluß 21 und den zweiten Anschluß 22, wobei der erste Anschluß 21 an der Oberseite des Gebiets 20 und wobei der zweite Anschluß 22 an der Unterseite des Gebiete 20 vorgesehen ist, wird ein ebenfalls nichtdargestelltes zweites elektrisches Feld erzeugt, welches im Wesentlichen parallel zur Einbringrichtung der Ladungsträger 30 in das Gebiet 20vorgesehen ist.

Die gemäß Figur 3 beschriebene erste Ausführungsform der erfindungsgemäßen Vorrichtung 10 ist besonders vorteilhaft für hochsensitive Magnetfeldsensoren, da durch den Verstärkungseffekt der seitlichen Ablenkung von Ladungsträgern 30 auch sehr geringe Magnetfelder 12 eine hinreichend große makroskopisch meßbare Ablenkung erzeugen.

Kern der vorliegenden Erfindung beruht auf der Anwendung des Prinzips der lateralen Ablenkwinkelverstärkung durch eine geeignete Potentialberg-Struktur. Die Art der Detektion der abgelenkten Ladungsträger 30 kann auf verschiedene Weise sehr vorteilhaft realisiert werden. Insbesondere ist das beschriebene Verstärkungsprinzip sowohl auf laterale als auch auf vertikale Bauelemente anwendbar. Die beschriebene laterale Potentialbergstruktur kann sowohl in vertikalen, d.h. der zentrale Hauptstromfluss geschieht von der Chipvorder- zur Chiprückseite und ein derartiges Element ist sensitiv auf Magnetfelder, die parallel zur.Chipoberfläche ausgerichtet sind, als auch in lateralen Bauelementen, d.h. der zentrale Hauptstromfluss ist parallel zur Chipoberfläche vorgesehen und ist sensitiv auf Magnetfelder 12, die senkrecht zur Chipoberfläche gerichtet sind, realisiert werden. Die Wahl, ob ein vertikales oder ein laterales Bauelement bevorzugt wird, muß je nach Anwendung in Abhängigkeit des favorisierten Stromflusses bzw. der favorisierten Orientierung des zu messenden Magnetfeldes gewählt werden.

Dementsprechend vielfältig sind auch die erfindungsgemäßen Kontaktierungs- und Auswertemöglichkeiten. Eine erste Ausführungsform ist bereits in Figur 3 dargestellt, bei der durch die seitlichen Kontakten eine Strom- oder Spannungsänderung gemessen werden kann, während der Hauptstrom senkrecht zwischen den Anschlüssen 21, 22 fließt.

In Figur 4 ist eine zweite Ausführungsform der erfindungsgemäßen Vorrichtung 10 dargestellt. Gleiche Bezeichnungen aus vorangehenden Figuren entsprechen gleichen Teilen, Komponenten bzw. Richtungen. Oberhalb des Gebiets 20 ist wiederum der erste Anschluß 21 im Wesentlichen mittig in x-Richtung vorgesehen, während der zweite Anschluß 22 mittig auf der Unterseite des Gebiets 20 vorgesehen ist. Die Elektroden 23 und 24 sind in der zweiten Ausführungsform der erfindungsgemäßen Vorrichtung ebenfalls auf der Unterseite, jedoch seitlich vom zweiten Anschluß 22 vorgesehen. Zwischen ihnen befindet sich ein Spannungsmeßinstrument 45, welches das Meßsignal der erfindungsgemäßen Vorrichtung 10 abgreifbar macht. In Figur 4 ist weiterhin ein erster Strompfad 41 vorgesehen, der bei Abwesenheit bzw. bei Verschwinden der B-Komponente 12 im Wesentlichen als einziger vom am ersten Anschluß 21 in das Gebiet 20 eintretenden nichtdargestellten Ladungsträgern 30 benutzt wird. Weiterhin ist auf der linken Seite des Gebiets 20 ein zweiter Strompfad 42 von dem ersten Anschluß 21 zur ersten Elektrode 32 in gestrichelter Linie dargestellt. Der zweite Strompfad 42 wird von am ersten Anschluß 21 in das Gebiet 20 eintretenden Ladungsträgern 30 bei eingeschalteter B-Komponente 12 bevorzugt beschritten, weil solche Ladungsträger 30, die in Figur 4 wie gesagt nicht dargestellt, einer ersten Trajektorie 35 folgen, die sich aus dem Ablenkeffekt der B-Komponente 12 ergibt, wenn die Ladungsträger exakt mittig vom ersten Anschluß 21 in das Gebiet 20 eintreten. Ein Ladungsträger 30, der vom ersten Anschluß 21 seitlich rechts versetzt in das Gebiet 20 eintritt, wird gemäß der Figur 4 beispielsweise entsprechend einer zweiten Trajektorie 36 bewegt werden. Ein dritter Strompfad 43 wird im in Figur 4 dargestellten Beispiel bei eingeschalteter B-Komponente 12 eine geringere Anzahl von Ladungsträgern aufweisen, da selbst Ladungsträger, die aufgrund ihres Eintritts in das Gebiet 20 vom ersten Anschluß 21 aus zur Bewegung gemäß dem zweiten Strompfad 42 vorgesehen sind, sich nicht auf diesem, sondern beispielsweise gemäß der zweiten Trajektorie 36 bewegen. Durch diese Asymmetrie zwischen dem zweiten Strompfad 42 und dem dritten Strompfad 43 kommt es zwischen der ersten Elektrode 23 und der zweiten Elektrode 24 zu einer mittels der Meßeinrichtung 45 erkennbaren Potentialdifferenz.

In Figur 5 ist eine dritte Ausführungsform der erfindungsgemäßen Vorrichtung 10 dargestellt. Gleiche Bezugszeichen aus vorangehenden Figuren bezeichnen gleiche Komponenten bzw. Richtungen der beschriebenen Gegenstände. Vorgesehen ist wiederum das Gebiet 20 welches auf seiner Oberseite den ersten Anschluß 21 und auf seiner Unterseite den zweiten Anschluß 22 vorsieht, zwischen denen der erste Strompfad 41 verläuft. Im Gegensatz zu Figur 4 bzw. der zweiten Ausführungsform der erfindungsgemäßen Vorrichtung 10 sind in der dritten Ausführungsform der Vorrichtung 10 jedoch die Elektroden 23, 24 auf der Oberseite des Gebiets 20 seitlich neben dem ersten Anschluß 21 vorgesehen. Der zweite Strompfad 42 und der dritte Strompfad 43 sind daher stärker gekrümmt als in Figur 4 vorgesehen und zwar entsteht in Figur 5 sogar eine Stromrichtungsumkehr innerhalb des Gebiets 20. Beispielhaft sind wiederum eine erste Trajektorie 35 und eine zweite Trajektorie 36 dargestellt.

In Figur 6 ist ein viertes Ausführungsbeispiel der erfindungsgemäßen Vorrichtung 10 dargestellt, welches im Wesentlichen mit dem dritten Ausführungsbeispiel aus der Figur 5 übereinstimmt. Der einzige Unterschied ist, dass auf der Oberseite des Gebiets 20 zwischen dem ersten Anschluß 21 und jeweils den seitlich angeordneten Elektroden 23, 24 Abschirmgebiete 26, 27 derart vorgesehen sind, dass zwischen dem ersten Anschluß 21 und der ersten Elektrode 23 ein erstes Abschirmgebiet 26 und dass zwischen dem ersten Anschluß 21 und der zweiten Elektrode 24 ein zweites Abschirmgebiet 27 vorgesehen sind. Die Abschirmgebiete 26, 27 können beispielsweise als Diffusionsgebiete vorgesehen werden, z.B. p-dotierte Gebiete, wenn das Gebiet 20 n-dotiert vorgesehen ist, wobei die Abschirmgebiete 26, 27 in Sperrrichtung gepolt einen lateralen Oberflächenstrom unterdrücken. Die Abschirmung kann aber auch in Form von geätzten Grabenstrukturen oder durch Implantation realisiert werden. Ferner besteht die Möglichkeit, den Oberflächenstrom im Bereich der Abschirmgebiete 26, 27 durch ein abstoßendes elektrisches Feld zu unterdrücken. Analog zu der leitenden Kanalbildung in einem MOS-Transistor, bei dem unterhalb der Gateelektrode durch eine geeignete Spannung ein leitfähiger Kanal gebildet wird, kann man analog das Gegenteil bewirken: Eine ladungsträgerabstoßende Spannung (z.B. negativ für Elektronenfluss) an einer oberhalb der Abschirmgebiete vorgesehenen Gateelektrode unterdrückt den lateralen Oberflächenstrom und zwingt die Ladungsträger in der Tiefe des Gebiets 20 zu fließen, wo sie wesentlich effizienter den Halleffekt nutzen als an der stark mit Oberflächenstörstellen beeinträchtigten Chipoberseite. Die Abschirmgebiete 26, 27 bewirken, dass Blindströme 46, 47 unterdrückt werden, wobei ein erster Blindstrom 46 zwischen dem ersten Anschluß 21 und der ersten Elektrode 23 direkt an der Oberfläche des Gebiets 20 verläuft und wobei ein zweiter Blindstrom 47 an der Oberfläche des Gebiets 20 direkt von dem ersten Anschluß 21 zur zweiten Elektrode 24 verläuft. Ansonsten sind in Figur 6 wiederum für gleiche Komponenten und Orientierungen aus vorangehenden Figuren die gleichen Bezugszeichen verwendet.

Die Erfindung betrifft zusammenfassend generell Vorrichtungen 10 zur Messung einer B-Komponente 12, wobei die Wirkung der B-Komponente 12 durch eine Kraftwirkung einer Potentialberg-Struktur verstärkt wird, die zum einen lateral zur ungestörten Bewegungsrichtung (Erstbewegungsrichtung 31) verläuft und die andererseits mit zunehmendem Abstand vor der im Allgemeinen mittig relativ zum Gebiet 20 angeordneten ungestörten Flugbahn der ersten Bewegungsrichtung 31 selbst eine ansteigende Kraftwirkung aufweist. Anlaß für diese Kraftwirkung kann sowohl eine Driftbewegung, beispielsweise durch elektrische Felder, durch eingebaute Potentiale oder durch Gradienten des Ferminiveaus oder auch eine Diffusionsbewegung, beispielsweise durch Teilchendichte-Gradienten, Diffusionsprofile und dergleichen bzw. eine Kombination einer Driftbewegung und einer Diffusionsbewegung sein.

Die Herstellung solcher Ablenkwinkel-verstärkenden Bauelemente bzw. erfindungsgemäßen Vorrichtungen 10 zur Messung einer B-Komponente 12 kann in verschiedenen Prozessen erfolgen, vorteilhaft sind beispielsweise Bipolar-, CMOS- oder BCD-Prozesse. Insbesondere ist vorteilhaft, dass bei letzteren Prozessen die Möglichkeit einer Onchip-Integration des Sensorelementes zusammen mit der Ansteuer- und Auswertelogik, beispielsweise in Form eines Asic, vorgesehen ist.

Auf der Basis der erfindungsgemäßen Vorrichtung ist es insbesondere möglich, hochempfindliche Magnetfeldsensoren und Strommesser, die auf der Messung des Magnetfelds des zu messenden Stroms beruhen, darzustellen. Hierbei ist insbesondere der Einsatz solcher Magnetfeldsensoren und Strommesser in Kraftfahrzeugen vorgesehen.

Erfindungsgemäß ist es ebenfalls vorgesehen, Anordnungen, wie beispielsweise Drehratensensoren, Drehwinkelsensoren und Drehmomentsensoren auf Basis einer Magnetfeldmessung mit einer erfindungsgemäßen Vorrichtung oder einem erfindungsgemäßen Magnetfeldsensor auszustatten. Eine solche Anordnung misst dann mit Hilfe der Vorrichtung bzw. des Magnetfeldsensors eine mechanische Bewegung über die Änderung eines Magnetfeldes, die sich beispielsweise durch die Lageänderung eines Permanentmagneten aufgrund der mechanischen Bewegung ergibt. Dadurch kann die Rotationsbewegung, der Drehwinkel, die Drehfequenz oder das Drehmoment beispielsweise eines Motors, einer Lenksäule, eines Lenkrades o.ä. über die Änderung des Magnetfeldes, d.h. beispielsweise über eine Winkeländerung des B-Feldvektors des Permanentmagneten am Sensorort, erkannt werden.

## Patentansprüche

1. Vorrichtung (10) zur Messung einer B-Komponente (12) eines Magnetfeldes, wobei die Vorrichtung (10) ein Gebiet (20) aufweist, wobei an einer Einbringungsstelle (21) gemäß einer Einbringungsrichtung (31) ein Ladungsträger (30) einbringbar ist, wobei sich der Ladungsträger (30) zunächst im Wesentlichen entlang der Einbringungsrichtung (31) bewegt, wobei die Einbringungsrichtung (31) senkrecht zu der B-Komponente (12) vorgesehen ist, wobei die Einbringungsstelle (21) bezüglich des Gebiets (20) im Wesentlichen mittig vorgesehen ist, wobei in dem Gebiet (20) eine Feldverteilung (50) eines ersten elektrischen Feldes vorgesehen ist, **dadurch gekennzeichnet, dass** ausgehend von der Einbringungsstelle (21) in einer x-Richtung, die sowohl im Wesentlichen senkrecht zu der B-Komponente (12) als auch im Wesentlichen senkrecht zu der Einbringungsrichtung (31) vorgesehen ist, die x-Komponente des ersten elektrischen Feldes in x-Richtung betragsmäßig monoton ansteigt, wodurch die Feldverteilung (50) eine lateralen Potenzialbergstruktur darstellt.

2. Vorrichtung gemäß Anspruch 1, **dadurch gekennzeichnet, dass** an das Gebiet (20) anschließend eine erste Elektrode (23) und eine zweite Elektrode (24) vorgesehen ist, wobei die erste und zweite Elektrode (23, 24) beidseitig von der Einbringungsstelle (21) in x-Richtung vorgesehen sind.

3. Vorrichtung gemäß Anspruch 1 oder 2, **dadurch gekennzeichnet, dass** ein erster Anschluß (21) und ein zweiter Anschluß (22) vorgesehen ist, wobei der erste oder der zweite Anschluß (21, 22) als Einbringungsstelle vorgesehen ist und wobei zwischen dem ersten und zweiten Anschluß (21, 22) ein zweites elektrisches Feld im Wesentlichen parallel der Einbringungsrichtung (31) im Gebiet (20) vorgesehen ist, wobei die Ladungsträger (30) mittels des zweiten elektrischen Feldes in das Gebiet (20) einbringbar sind.

4. Vorrichtung nach einem der Ansprüche 1, 2 oder 3, **dadurch gekennzeichnet, dass** die Erzeugung der lateralen Potenzialbergstruktur der Feldverteilung (50) durch ein laterales elektrisches Feld erfolgt..

5. Vorrichtung nach einem der Ansprüche 1, 2 oder 3, **dadurch gekennzeichnet, dass** die Erzeugung der lateralen Potenzialbergstruktur Feldverteilung (50) durch laterale Teilchengradienten erfolgt.

6. Vorrichtung nach einem der Ansprüche 1, 2 oder 3, **dadurch gekennzeichnet, dass** die Erzeugung der lateralen Potenzialbergstruktur der Feldverteilung (50) durch ein laterales Dotierungsprofil erfolgt.

7. Vorrichtung nach einem der Ansprüche 1, 2 oder 3, **dadurch gekennzeichnet, dass** die Erzeugung lateralen Potenzialbergstruktur der Feldverteilung (50) durch Modulation der Bandkanten oder durch Modulation des Ferminiveaus im Ortsraum, insbesondere durch eingebaute Potentialberge in n-i-p-i-Strukturen, erfolgt.

8. Magnetfeldsensor mit einer Vorrichtung zur Messung einer B-Komponente (12) eines Magnetfeldes nach einem der Ansprüche 1 bis 7, **dadurch gekennzeichnet, dass** der Magnetfeldsensor eine Auswerteschaltung zur Auswertung der Signale der Vorrichtung (10) umfasst.

9. Magnetfeldsensor nach Anspruch 8, **dadurch gekennzeichnet, dass** die Vorrichtung (10) und die Auswerteschaltung auf einem Halbleitersubstrat monolithisch integriert ist.

10. Strommesser oder Anordnung mit einer Vorrichtung (10) nach einem der Ansprüche 1 bis 7 oder mit einem Magnetfeldsensor nach einem der Ansprüche 8 oder 9.

## Claims

1. Apparatus (10) for measuring a B-component (12) of a magnetic field, the apparatus (10) having a region (20), it being possible to introduce a charge carrier (30) at an introduction point (21) in accordance with an introduction direction (31), the charge carrier (30) initially moving essentially along the introduction direction (31), the introduction direction (31) being provided perpendicular to the B-component (12), the introduction point (21) being provided essentially in the middle of the region (20), and a field distributor (50) for a first electric field being provided in the region (20), **characterized in that**, starting from the introduction point (21) in an x-direction which is provided both essentially perpendicular to the B-component (12) and essentially perpendicular to the introduction direction (31), the magnitude of the x-component of the first electric field rises monotonically in the x-direction, as a result of which the field distributor (50) represents a lateral potential hill structure.

2. Apparatus according to Claim 1, **characterized in that** a first electrode (23) and a second electrode (24) are provided so as to adjoin the region (20), the first and second electrodes (23, 24) being provided on either side of the introduction point (21) in the x-direction.

3. Apparatus according to Claim 1 or 2, **characterized in that** a first connection (21) and a second connection (22) are provided, the first or the second connection (21, 22) being provided as the introduction point and a second electric field being provided in the region (20) between the first and second connections (21, 22) essentially parallel to the introduction direction (31), it being possible to introduce the charge carriers (30) into the region (20) by means of the second electric field.

4. Apparatus according to one of Claims 1, 2 or 3, **characterized in that** the lateral potential hill structure of the field distributor (50) is produced by a lateral electric field.

5. Apparatus according to one of Claims 1, 2 or 3, **characterized in that** the lateral potential hill structure of the field distributor (50) is produced by lateral particle gradients.

6. Apparatus according to one of Claims 1, 2 or 3, **characterized in that** the lateral potential hill structure of the field distributor (50) is produced by a lateral doping profile.

7. Apparatus according to one of Claims 1, 2 or 3, **characterized in that** the lateral potential hill structure of the field distributor (50) is produced by modulating the band edges or by modulating the Fermi level in the local area, in particular by built-in potential hills in n-i-p-i structures.

8. Magnetic field sensor having an apparatus for measuring a B-component (12) of a magnetic field according to one of Claims 1 to 7, **characterized in that** the magnetic field sensor comprises an evaluation circuit for evaluating the signals from the apparatus (10).

9. Magnetic field sensor according to Claim 8, **characterized in that** the apparatus (10) and the evaluation circuit are monolithically integrated on a semiconductor substrate.

10. Ammeter or arrangement having an apparatus (10) according to one of Claims 1 to 7 or having a magnetic field sensor according to either of Claims 8 and 9.

## Revendications

1. Dispositif (10) pour mesurer une composante B (12) d'un champ magnétique, le dispositif (10) présentant un domaine (20) où un porteur de charge (30) peut être amené sur une position d'introduction (21) suivant une direction d'introduction (31), le porteur de charge (30) se déplaçant tout d'abord essentiellement le long d'une direction d'introduction (31), prévue perpendiculaire à la composante B (12) et la position d'introduction (21) étant essentiellement centrée par rapport au domaine (20), une distribution du champ (50) d'un premier champ électrique étant prévue dans le domaine (20),
**caractérisé en ce qu'**
à partir de la position d'introduction (21) dans une direction x à la fois essentiellement perpendiculaire à la composante B (12) et essentiellement perpendiculaire à la direction d'introduction (31), la composante x du premier champ électrique monte en valeur dans la direction x de façon monotone, la distribution du champ (50) représentant ainsi une structure latérale à colline de potentiel.

2. Dispositif selon la revendication 1,
**caractérisé en ce qu'**
une première électrode (23) et une seconde électrode (24) contiguës au domaine (20), sont disposées des deux côtés de la position d'introduction (21) dans la direction x.

3. Dispositif selon la revendication 1 ou 2,
**caractérisé par**
un premier raccord (21) et un second raccord (22), le premier ou le second raccord (21, 22) étant prévu comme position d'introduction avec un deuxième champ électrique essentiellement parallèle à la direction d'introduction (31) prévu entre le premier et le second raccord (21, 22) dans le domaine (20), les porteurs de charge (30) pouvant être amenés dans le domaine (20) au moyen du deuxième champ électrique.

4. Dispositif selon l'une des revendications 1, 2 ou 3,
**caractérisé en ce que**
la production de la structure latérale à colline de potentiel de la distribution du champ (50) s'effectue par un champ électrique latéral.

5. Dispositif selon l'une des revendications 1, 2 ou 3,
**caractérisé en ce que**
la production de la structure latérale à colline de potentiel de la distribution du champ (50) s'effectue par des gradients particulaires latéraux.

6. Dispositif selon l'une des revendications 1, 2 ou 3,
**caractérisé en ce que**
la production de la structure latérale à colline de potentiel de la distribution du champ (50) s'effectue par un profil de dopage latéral.

7. Dispositif selon l'une des revendications 1, 2 ou 3,
**caractérisé en ce que**
la production de la structure latérale à colline de potentiel de la distribution du champ (50) s'effectue par modulation des limites de bande ou par modulation du niveau de Fermi dans l'espace des coordonnées, notamment par des collines de potentiel intégrées dans des structures n-i-p-i.

8. Capteur de champ magnétique comportant un dispositif pour mesurer une composante B (12) d'un champ magnétique selon l'une des revendications 1 à 7,
**caractérisé en ce que**
le capteur de champ magnétique comprend un circuit d'exploitation des signaux du dispositif (10).

9. Capteur de champ magnétique selon la revendication 8,
**caractérisé en ce que**
le dispositif (10) et le circuit d'exploitation sont intégrés de manière monolithique sur un substrat semi-conducteur.

10. Ampèremètre ou ensemble comportant un dispositif (10) selon l'une des revendications 1 à 7 ou comportant un capteur de champ magnétique selon l'une des revendications 8 ou 9.
